# EUROPÄISCHE PATENTSCHRIFT

(11) **EP 2 135 286 B1**
(45) Veröffentlichungstag und Bekanntmachung des Hinweises auf die Patenterteilung: **23.09.2015**
(21) Anmeldenummer: 08717012.2
(22) Anmeldetag: 21.02.2008
(51) Int. Cl.: H01L 29/778, H01L 29/40, H01L 29/47, H01L 29/812, H01L 29/423, H01L 29/66

(54) **HALBLEITERBAUELEMENT MIT FELDPLATTENSTRUKTUR UND VERFAHREN ZU DESSEN HERSTELLUNG**
SEMICONDUCTOR COMPONENT WITH FIELD PLATE STRUCTURE AND METHOD FOR PRODUCING THE SAME
DISPOSITIF SEMI-CONDUCTEUR AVEC STRUCTURE À PLAQUES DE CHAMP ET PROCÉDÉ POUR LE PRODUIRE

(30) Priorität: 22.02.2007 DE 102007010562
(43) Veröffentlichungstag der Anmeldung: 23.12.2009
(73) Patentinhaber: Forschungsverbund Berlin E.V., 12489 Berlin (DE)
(72) Erfinder: BAHAT-TREIDEL, Eldat, 10557 Berlin (DE); SIDOROV, Victor, 12157 Berlin (DE); WUERFL, Joachim, 15738 Zeuthen (DE)
(74) Vertreter: Gulde & Partner
(86) Internationale Anmeldenummer: PCT/EP2008/052131
(87) Internationale Veröffentlichungsnummer: WO 2008/101989

(56) Entgegenhaltungen:
- WO-A-03/012854
- WO-A-2006/098801
- US-A- 4 947 232
- US-A1- 2005 161 761
- SEUNG-CHUL LEE ET AL: "High Breakdown Voltage GaN Schottky Barrier Diode employing Floating Metal Rings on AlGaN/GaN Hetero-junction" POWER SEMICONDUCTOR DEVICES AND ICS, 2005. PROCEEDINGS. ISPSD '05. THE 17TH INTERNATIONAL SYMPOSIUM ON SANTA BARBARA, CA, USA MAY 23-26, 2005, PISCATAWAY, NJ, USA,IEEE, 23. Mai 2005 (2005-05-23), Seiten 247-250, XP010820737 ISBN: 978-0-7803-8890-1

## Beschreibung

Die vorliegende Erfindung betrifft ein Halbleiterbauelement und ein Verfahren zu dessen Herstellung, insbesondere betrifft die vorliegende Erfindung einen Transistor, bei dem das elektrische Feld mittels Feldplatten in der aktiven Region (Kanal) in kritischen Gebieten reduziert (kontrolliert) und dadurch das elektrische Feld entlang des Bauelements gleichmäßiger verkeilt wird, wodurch die Leistung des Bauelements verbessert werden kann.

Feldplatten werden üblicherweise in einer großen Auswahl von Halbleiterbauelementen wie HEMTs, MISFETs, MOSFETs usw. eingesetzt. Die Feldplatten werden benötigt, um das elektrische Feld in kritischen Gebieten (Kanal) zu kontrollieren und damit bestimmte Bauelementeigenschaften zu erreichen (z.B. höhere Durchbruchsfestigkeit oder bessere Linearität). Das elektrische Feld wird entlang des Bauteils (Kanal) gleichmäßiger verteilt, wodurch die Leistung des Bauelements verringert werden kann.

Feldplatten können mit verschiedenen Potentialquellen und Elektroden verbunden werden oder auch alleine stehen, ohne an ein definiertes Potenzial angeschlossen zu sein (sog. "erdfrei", "floating" oder "freischwebend"). Obwohl Feldplatten nützlich sind, um elektrische Feldgradienten zu reduzieren, weisen sie einen grundsätzlichen Nachteil auf, da sie die Kapazitäten des Bauelements erhöhen und die Leistung im Hochfrequenzbereich verschlechtern, denn durch die vergrößerte Bauelementkapazität führen sie zu einer reduzierten Grenzfrequenz des Bauelements.

Eine einheitliche Feldplatte (d.h. genau eine Feldplatte, die im Bereich des Kanals angeordnet), z.B. ein Feldeffekttransistor mit einer einheitlichen Feldplatte, die mit dem Gatepotential verbunden ist, erzeugt zwei separate Spitzen des elektrischen Felds entlang des Kanals, wobei sich eine Spitze nahe der drainseitigen Kante und die andere Spitze nahe der gateseitigen Kante der Drainelektrode befindet. Das bedeutet, dass das Feld im Bauteil lokal immer noch sehr stark konzentriert ist und sehr hohe Absolutwerte aufweist. Um dieses Problem zu überwinden und die Feldspitzen zu glätten, wurden in US 2005/0253168 und in X. Huili et al. ("High breakdown voltage AlGaN-GaN HEMTs achieved by multiple field plates," Electron Device Letters, IEEE, vol. 25, no. 4, pp. 161-163, 2004) zwei übereinander gestapelte Feldplatten vorgeschlagen. In diesen Bauelementen treten elektrische Feldspitzen bei jeder der gestapelten Feldplatten auf und verteilen so das Feld gleichmäßiger entlang des Kanals.

Halbleiter basierte Transistoren mit Feldplatten sind aus US 2005/0161761 A1, WO 2006/098801 A1, WO 03/012854 A1 und aus Lee et. al.: High Breakdown Voltage GaN Schottky Barrier Diode employing Floating Metal Rings on AlGaN/GaN Hetero-junction. Nachteilig an den im Stand der Technik vorgeschlagenen gestapelten Feldplatten sind die hohen Kosten zur Herstellung des Bauelements aufgrund der hohen Anzahl notwendiger Prozessschritte sowie die Fehleranfälligkeit aufgrund der Notwendigkeit einer sehr genauen Ausrichtung der Feldplatten zueinander.

Es ist daher Aufgabe der vorliegenden Erfindung, einen Transistor und ein Verfahren zu dessen Herstellung anzugeben, bei dem das elektrische Feld in der aktiven Region geglättet ist (bzw. Feldspitzen reduziert sind), wobei das Bauelement preiswerter und einfacher herstellbar ist und darüber hinaus eine höhere Prozessausbeute erzielt werden kann. Ferner sollen Anpassungen des Halbleiterbauelements an unterschiedliche Erfordernisse bzgl. der Verteilung des elektrischen Felds in besonders einfacher Weise möglich sein.

Diese Aufgaben werden erfindungsgemäß durch die Merkmale der unabhängigen Patentansprüche 1 und 7 gelöst. Bevorzugte Ausgestaltungen der Erfindung sind in den Unteransprüchen enthalten.

Die Idee der Erfindung besteht darin, eine Vielzahl von separaten Feldplatten (auch Finger genannt) durch einen gemeinsamen Prozessierungsschritt zu erzeugen, wobei die Feldplatten das elektrische Feld entlang des Kanals gleichmäßiger verteilen. Dadurch kann ein Transistor mit relativ geringen (d.h. geglätteten) Feldspitzen (im Bereich der drainseitigen Kante/gateseitigen Kante) bei gleichzeitig geringer Kapazität besonders einfach hergestellt werden.

Separat bedeutet, dass die aus einem elektrisch leitenden Material bestehenden Feldplatten nicht direkt in (körperlichem) Kontakt miteinander stehen. Somit sind die Feldplatten nicht direkt elektrisch miteinander verbunden. Es ist aber denkbar, dass die Feldplatten mittelbar elektrisch miteinander verbunden sind, beispielsweise über die Gateelektrode oder das Gatepad. Durch die erfindungsgemäße Ausgestaltung werden Feldspitzen an der drainseitigen Kante des Gatekontakts und an der gateseitigen Kante des Drainkontakts effizient verringert. Vorzugsweise ist die Vielzahl von separaten Feldplatten (d.h. von mindestens 2 Feldplatten) periodisch zueinander entlang des Kanals angeordnet. Es ist aber auch möglich, dass die Vielzahl von separaten Feldplatten nicht periodisch zueinander angeordnet ist. Erfindungsgemäß überlappen sich die einzelnen Feldplatten in einer zum Trägersubstrat des Transistors senkrechten Projektion auf den Kanal nicht. Vorzugsweise sind erfindungsgemäß im Bereich des Kanals (aktive Region) zwischen 2 und 50 separate Feldplatten, noch bevorzugter zwischen 2 und 10 separate Feldplatten angeordnet.

Die Feldplatten werden vorzugsweise durch Lithographie festgelegt. Es können aber auch alternative Verfahren zum hochaufgelösten Aufbringen und Strukturieren von elektrisch leitendem Material verwendet werden.

Die Feldplatten bestehen aus einem elektrisch leitenden Material, vorzugsweise aus einer Schichtstruktur Titan/Gold (besonders bevorzugt 30 nm/500nm) oder Aluminium. Alternativ können auch andere nicht korrosive Metalle verwendet werden. Jeder der Finger (= jede der Vielzahl von Feldplatten) des leitenden Materials kann an eine unterschiedliche Elektrode des Transistors (vorzugsweise HEMT, MISFET, MOSFET) angeschlossen werden (beispielsweise Gate, Source, Drain) oder kann alternativ auch an keine Elektrode angeschlossen sein, in diesem Fall wird die Feldplatte "erdfrei" (floating) genannt. Dadurch ergeben sich erfindungsgemäß viele Freiheitsgrade, um die Feldverteilung unter der Feldplattenstruktur zu optimieren. Die optimale Konfiguration kann vorzugsweise durch physikalisch orientierte Bauelementesimulation ermittelt werden. Ein besonderer Vorteil besteht darin, die Feldplattenstruktur und die selektive Zuweisung der einzelnen Finger der Feldplattenstruktur mit einem einzigen standardmäßigen (lithographischen) Prozess zu erzeugen. Weiterhin ist es vorteilhaft, die Finger der Anordnung einzeln adressieren zu können.

Die Länge des Kanals (d.h. der Abstand zwischen Source- und Drainkontakt) beträgt vorzugsweise zwischen 3 und 100 µm, bevorzugter zwischen 3 und 12 µm. Die Länge der Feldplatten entlang des Kanals (also in Richtung des Stromflusses) beträgt vorzugsweise zwischen 1µm und 100 µm, besonders bevorzugt zwischen 3 µm und 12 µm. Die Breite der Feldplatten senkrecht zum Kanal beträgt vorzugsweise zwischen 50-500 µm.

Die Feldplattenstruktur wird während des Gateschichtprozesses und während des Gate-Feldplatten-Schicht-Prozess hergestellt. Im ersten Schicht-Prozess werden die Finger des Feldplattengitters in der gleichen Ebene wie die eigentliche Gatestruktur beispielsweise mit Elektronenstrahllithographie realisiert. Im zweiten Schicht-Prozess werden die Finger des

Feldplattengitters in einer optionalen weiteren Metallisierungsebene hergestellt. Der herausragende Vorteil der vorgeschlagenen Feldplattentechnologie liegt in ihrer Einfachheit, d.h. ohne Einführung zusätzlicher Prozessierungsebenen. Dadurch kann ein robuster und reproduzierbarer Prozess gewährleistet werden, da beispielsweise die bei gestapelten Feldplatten zwangsweise auftretenden Justageprobleme vollständig entfallen.

Die erfindungsgemäße Feldplattenstruktur ermöglicht es, jeden einzelnen Feldplattenfinger mit unterschiedlichen elektrischen Potentialen wie den Source-, Drain- oder Gatepotenzial zu verbinden oder driftend (floating) zu lassen, vorzugsweise im Fall eines FET-Designs. Die einzelnen Feldplatten der Feldplattenstruktur an unterschiedliche externe Potenziale anzuschließen ermöglicht eine abstimmbare Feldplattenstruktur, wobei das interne elektrische Feld durch das Layout der Feldplattenstruktur beeinflusst werden kann, wohingegen das Verfahren zur Herstellung nahezu gleich bleibt. Damit können die Eigenschaften des Bauelements individuell optimiert und besser für die spezifischen Bedürfnisse angepasst werden.

Neben der Einfachheit des erfindungsgemäßen Verfahrens hat eine Feldplattenstruktur den Vorteil einer kleineren Kapazität als eine einheitliche Feldplatte aufgrund des dielektrischen Abstands zwischen den Gitterlinien. Die Reduktion der Kapazität wird vorzugsweise durch "erdfreie" Feldplattenfinger und/oder ein niedriges Verhältnis des Linienabstandsrasterung (Lₛ/Lₗ >1) erreicht. Vorzugsweise ist das Verhältnis des Abstandes zwischen zwei benachbarten Feldplatten und der Länge der Feldplattenfinger größer 1.5, noch bevorzugter größer 2 und noch bevorzugter größer 3. Die erfindungsgemäße Feldplattenstruktur ist daher auch für Hochfrequenzanwendungen (HEMT) verwendbar.

Das erfindungsgemäße Verfahren weist die Verfahrensschritte des Anspruchs 1 auf.

Vorzugsweise werden die Feldplatten unter Verwendung eines photolithographischen Verfahrens aufgebildet. Vorzugsweise werden die zusätzlichen Feldplatten (Finger) gleichzeitig mit dem Prozess zur Ausbildung des Gatekontakts und gleichzeitig mit dem Prozess zur Ausbildung des Gate-Feldplatte ausgebildet. Erfindungsgemäß wird vor dem Aufbringen der mindestens zwei zusätzlichen Feldplatten eine Passivierungsschicht auf die aktive Schichtstruktur aufgebracht und vorzugsweise werden die mindestens zwei zusätzlichen Feldplatten (gleichzeitig) auf die Passivierungsschicht aufgebracht. Vorzugsweise werden die mindestens zwei Feldplatten streifenförmig und zueinander parallel ausgebildet. Vorzugsweise weist die aktive Schichtstruktur eine erste Schicht aus einem ersten halbleitenden Material und eine zweite Schicht aus einem zweiten halbleitenden Material auf, wobei sich die Bandlücke des ersten halbleitenden Materials von der Bandlücke des zweiten halbleitenden Materials unterscheidet, und das erste halbleitende Material und das zweite halbleitende Material derart gewählt sind, dass in der Grenzschicht zwischen erster Schicht und zweiter Schicht ein zweidimensionales Elektronengas ausgebildet wird.

Vorzugsweise werden mindestens zwei Feldplatten mit unterschiedlichen elektrischen Potentialen verbunden. Vorzugsweise wird mindestens eine Feldplatte mit dem Drainkontakt und/oder mindestens eine Feldplatte mit dem Gatekontakt und/oder mindestens eine Feldplatte mit dem Sourcekontakt verbunden. Vorzugsweise wird mindestens eine Feldplatte freischwebend ("erdfrei") angeordnet. Vorzugsweise werden die Gate-Feldplatte und die mindestens zwei zusätzlichen Feldplatten mit einem Schutzfilm überzogen.

Die Passivierungsschicht und/oder der Schutzfilm weisen vorzugsweise eine Schichtdicke zwischen 100 nm und 300 nm auf. Die Passivierungsschicht und/oder der Schutzfilm bestehen vorzugsweise aus Siliziumdioxid, Aluminiumoxid oder Siliziumnitrid. Vorzugsweise werden mindestens zwei der zusätzlichen Feldplatten als Delta-Layer ausgebildet, d.h. die zusätzlichen Feldplatten weisen im Querschnitt entlang des Kanals eine Länge (lateral) auf, die kleiner als die Höhe (vertikal) ist. Vorzugsweise ist die Höhe mehr als doppelt so groß wie die Länge der Feldplatten. Dadurch kann die Kapazität des Bauelements weiter verringert werden. Die minimale Länge (laterale Ausdehnung entlang des Kanals) wird durch die Auflösung der verfügbaren Prozesstechnologie (beispielsweise Lithographie) nach unten begrenzt.

Das erfindungsgemäße Halbleiterbauelement weist die Merkmale des Anspruchs 7 aus.

Vorzugsweise sind die mindestens zwei Feldplatten streifenförmig und zueinander parallel ausgebildet. Vorzugsweise sind mindestens zwei zusätzliche Feldplatten nebeneinander und direkt auf der aktiven Schicht (oder direkt auf einer auf der aktiven Schicht vorhandenen Passivierungsschicht) angeordnet. Somit wird vorzugsweise zwischen der aktiven Schichtstruktur und mindestens zwei zusätzlichen Feldplatten eine Passivierungsschicht vorgesehen. Vorzugsweise sind mindestens zwei zusätzliche Feldplatten nebeneinander und direkt auf der Passivierungsschicht angeordnet. Vorzugsweise weist die aktive Schichtstruktur eine erste Schicht aus einem ersten halbleitenden Material und eine zweite Schicht aus einem zweiten halbleitenden Material auf, wobei sich die Bandlücke des ersten halbleitenden Materials von der Bandlücke des zweiten halbleitenden Materials unterscheidet, und das erste halbleitende Material und das zweite halbleitende Material derart gewählt sind, dass sich in der Grenzschicht zwischen erster Schicht und zweiter Schicht ein zweidimensionales Elektronengas ausbildet.

Vorzugsweise sind mindestens zwei Feldplatten mit unterschiedlichen elektrischen Potentialen verbunden. Vorzugsweise ist mindestens eine Feldplatte mit dem Drainkontakt und/oder mindestens eine Feldplatte mit dem Gatekontakt und/oder mindestens eine Feldplatte mit dem Sourcekontakt verbunden. Vorzugsweise ist mindestens eine Feldplatte erdfrei (bzw. freischwebend bzw. floating, d.h. nicht an ein bestimmtes Potential angelegt) angeordnet. Vorzugsweise sind die Gate-Feldplatte und die mindestens zwei Feldplatten mit einem Schutzfilm überzogen.

Die Erfindung wird nachstehend anhand von in den Figuren dargestellten Ausführungsbeispielen näher erläutert. Es zeigen
- Fig.1: einen High Electron Mobility Transistor mit einem Feldplattengitter (hergestellt in einer Metallisierungsebene) in schematischer, geschnittener Darstellung,
- Fig.2: einen High Electron Mobility Transistor mit einem Feldplattengitter in Aufsicht, wobei drei Finger mit der Gateelektrode verbunden und zwei Finger driftend angeordnet sind,
- Fig.3: einen High Electron Mobility Transistor mit einem Feldplattengitter, wobei zwei Finger mit der Gateelektrode, zwei Finger mit der Sourceelektrode und ein Finger mit der Drainelektrode verbunden sowie zwei Finger "erdfrei" angeordnet sind,
- Fig.4: einen High Electron Mobility Transistor mit einem erfindungsgemäßen Feldplattengitter in schematischer, geschnittener Darstellung, hergestellt in zwei verschiedenen Metallisierungsebenen,
- Fig.5: eine schematische Darstellung der Verteilung des elektrischen Felds im Kanalgebiet eines HEMT mit und ohne Feldplattengitter (Feldplatten-Struktur),
- Fig. 6: eine schematische Darstellung der bei der in Fig. 5 zugrundeliegenden Feldverteilung resultierenden Elektronenkonzentration im 2DEG zwischen der Gate- und der Drainelektrode, und
- Fig. 7: eine schematische Darstellung einer simulierten Verteilung des elektrischen Felds im 2-DEG-Feld in Source-Drain Richtung mit und ohne Feldplattengitter.

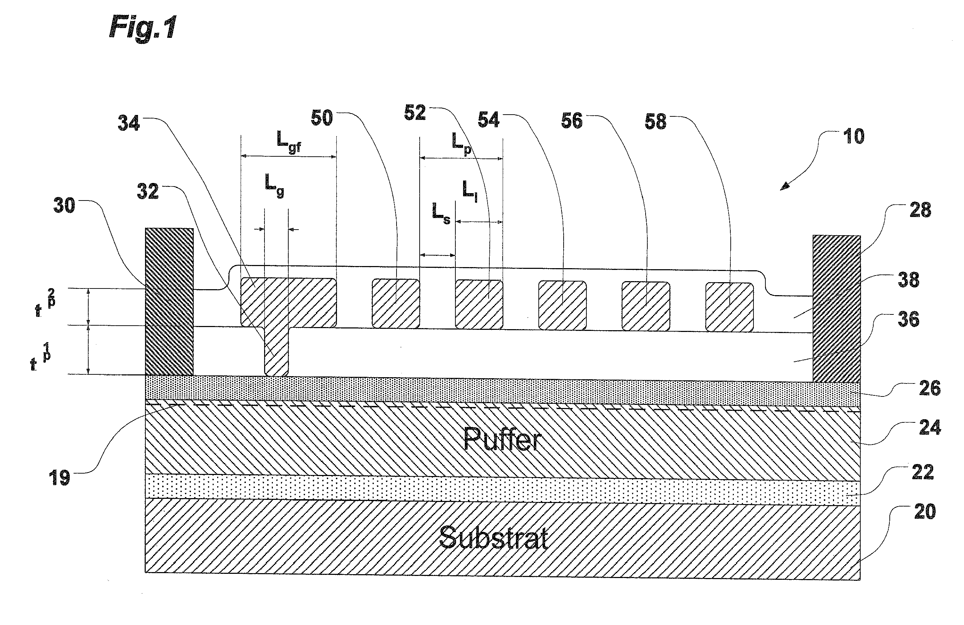

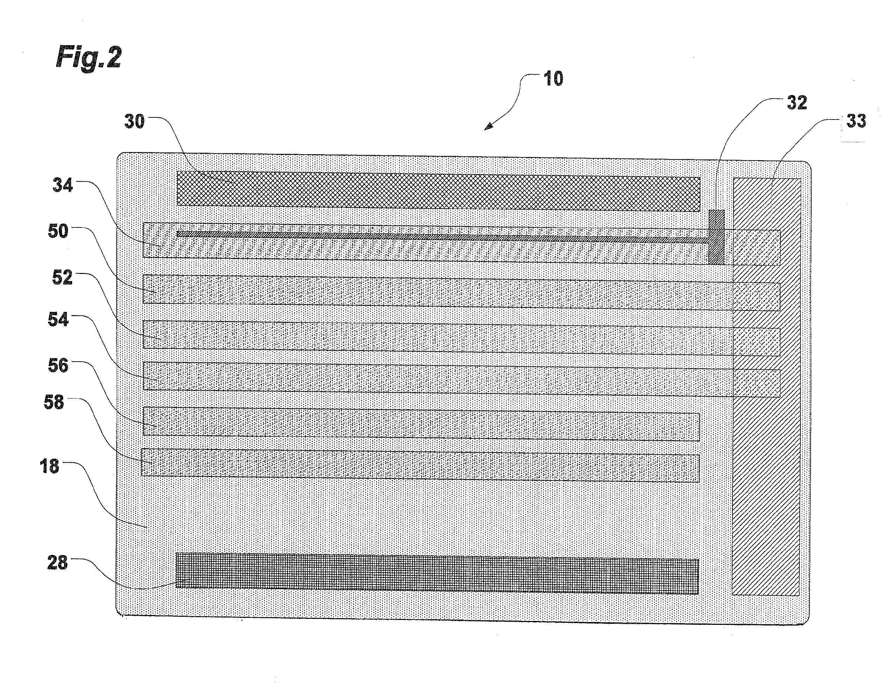

Fig. 1 und Fig. 2 zeigen einen High Electron Mobility Transistor mit einem Feldplattengitter hergestellt in einer Metallisierungsebene in geschnittener Darstellung/ in Aufsicht.

Auf einem Substrat 20 wird eine Nukleationsschicht 22 aufgebracht. Darauf wird nachfolgend eine Pufferschicht 24 aus einem halbleitenden Material aufgebracht. Auf der Pufferschicht 24 wird eine Barrierenschicht 26 aus einem halbleitenden Material aufgebracht. Die Pufferschicht 24 und die Barrierenschicht 26 sind mit deutlich unterschiedlicher Bandlücke und unterschiedlichen Fermi-Niveau ausgebildet, so dass sich ein zweidimensionales Elektronengas als Kanal zwischen Source 30 und Drain 28 ausbildet, wobei Source 30 und Drain 28 auf der Barrierenschicht 26 angeordnet sind. Um diese unterschiedliche Fermi-Energie auszugleichen und bei GaN Bauelementen wegen der unterschiedlichen spontanen und piezoelektrischen Polarisation in den Schichten 24 und 26, konzentrieren sich die Elektronen an der Grenzschicht zwischen den Schichten 24 und 26. Es bildet sich im Leitungsband ein relativ scharf auf die Grenzschicht begrenztes Energie-Minimum aus. Die Elektronen weisen parallel zu der Grenzschicht ein hohe Beweglichkeit auf. Hohe elektrische Felder treten bei moderaten Betriebsspannungen in erster Linie an der drainseitigen Kante des Gates auf, da wegen der hohen Kanalleitfähigkeit das Drainpotential praktisch unter dieser Gatekante anliegt. Erst bei noch höheren Betriebsspannungen bildet sich eine zweite Feldspitze am Drainkontakt aus.

Nachfolgend wird eine Passivierungsschicht 36, beispielsweise aus SiO₂, Al₂O₃ mit einer Schichtdicke zwischen 100-300 nm, ausgebildet.

In die Passivierungsschicht 36 wird mittels Standardtechniken (beispielsweise Lithographie) eine Aussparung (Diskontinuität) eingebracht. In die Aussparung wird das Gate 32 aufgebracht. Nachfolgend werden in einem einzigen Prozessierungsabschnitt gleichzeitig die Gate-Feldplatte 34 sowie die separaten Feldplatten 50, 52, 54, 56 und 58 aufgebracht. Die Gate-Feldplatte 34 und drei der Finger 50, 52, 54 werden elektrisch mit der Gatepadelektrode 33 verbunden und zwei sind "erdfreie" Finger 56, 58, d.h. sie sind mit keinem definierten Potential (wie Source, Drain oder Gate) verbunden.

Der gemeinsame Prozessierungsabschnitt kann durch Standardtechniken wie Lithographie, aber auch durch alternative Strukturierungsverfahren erfolgen. Entscheidend ist, dass auf der Passivierungsschicht 36 gleichzeitig mehrere separaten Feldplatten (die nicht mit dem Gate 32 verbunden sind) aufgebracht werden.

Abschließend wird eine Schutzschicht 38 aufgebracht, die die Gate-Feldplatte 34 sowie die separaten Feldplatten 50, 52, 54, 56 und 58 überdeckt.

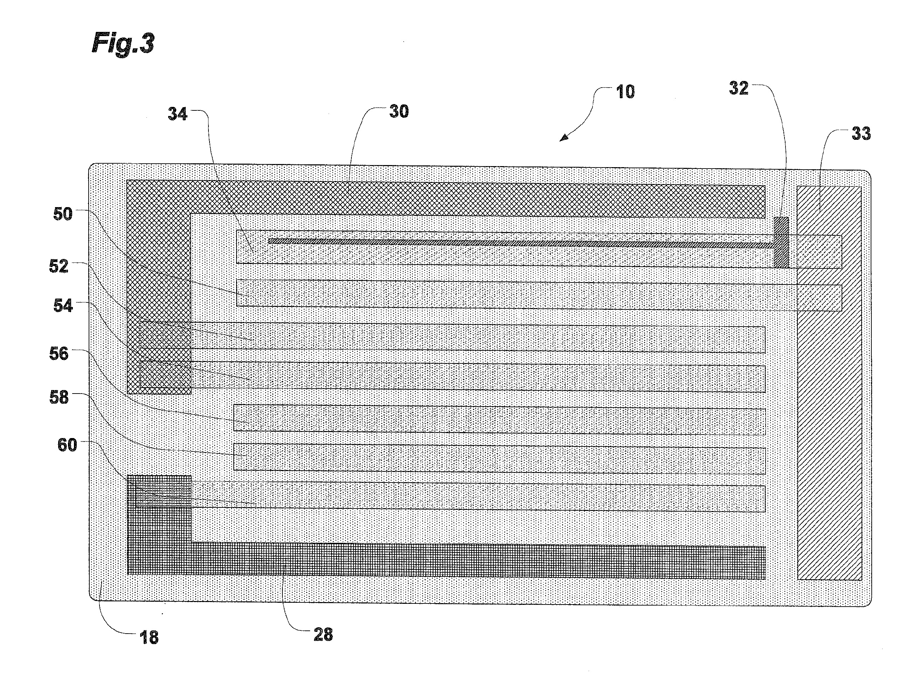

Fig. 3 zeigt ein weiteres Beispiel eines HEMT mit Feldplatten-Struktur. In diesem Fall sind verschiedene Finger der Feldplatten-Struktur verschiedenen Elektroden zugeordnet. Finger 50 ist mit dem Gatepad 33 verbunden, die Finger 52 und 54 sind mit dem Source-Pad 30 verbunden, die Finger 56 und 58 sind erdfrei und Finger 60 ist mit dem Drainpad 28 verbunden ist. Um die Feldverteilung unter der Feldplatten-Struktur zu optimieren, ist es auch möglich, einen Teil des Feldplattengitters mit einem beliebigen externen Potential zu verbinden.

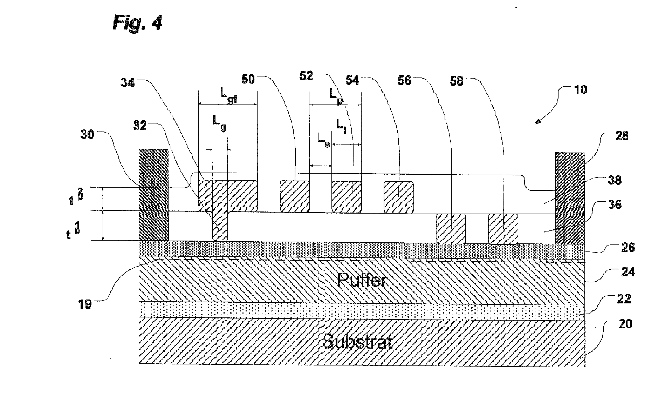

Fig. 4 zeigt ein Ausführungsbeispiel eines HEMTs mit erfindungsgemäßem Feldplattengitter. Hier werden die Finger 56 und 58 des Feldplattengitters in einer optionalen weiteren Metallisierungsebene hergestellt. Das bedeutet, dass die Passivierungsschicht 36 entsprechend strukturiert wird.

Die Erfindung ist jedoch nicht auf einen HEMT beschränkt, vielmehr kann die Erfindung für alle Arten von Feldeffekt-Transistoren angewendet werden, beispielsweise MISFETs und MOSFETs. Dementsprechend kann der Kanal alternativ auch durch eine einzelne Halbleiterschicht ausgebildet werden.

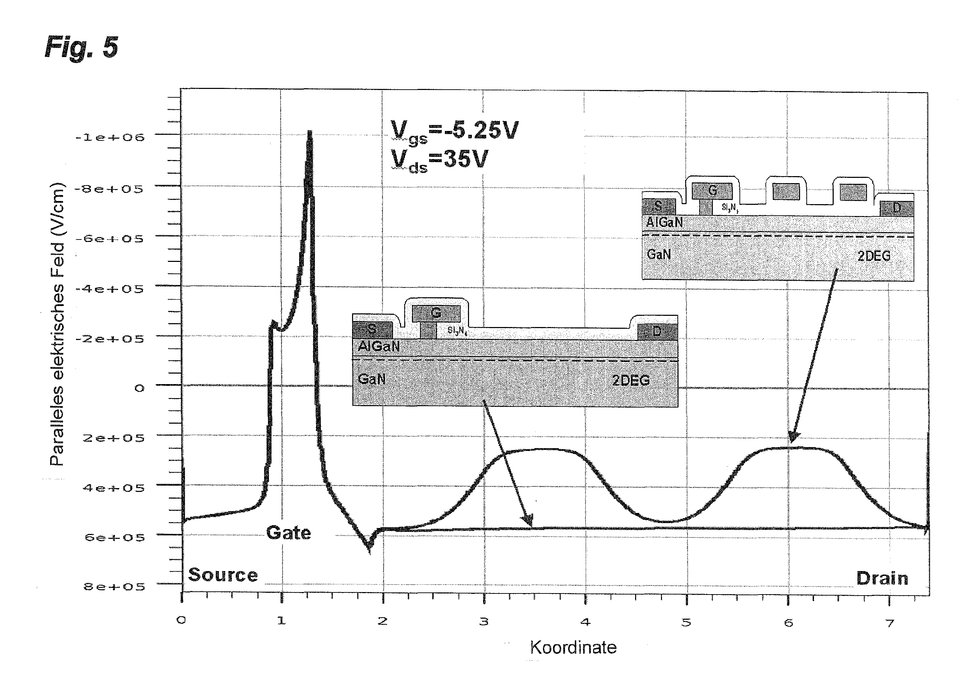

Fig. 5 zeigt eine schematische Darstellung der Verteilung des elektrischen Felds im Kanalbereich eines HEMT gemäß Fig 1. (mit Feldplattenstruktur) im Vergleich zu einem baugleichen HEMT ohne Feldplattenstruktur. Die Feldplatten sorgen bei einem gesperrten Transistor und hohen Sperrspannungen unmittelbar unter der Feldplatte für ein zusätzliches elektrisches Feld im Kanalbereich zwischen Gate und Drain und begrenzen dadurch die Feldspitze unmittelbar an der drainseitigen Kante der Gatestruktur.

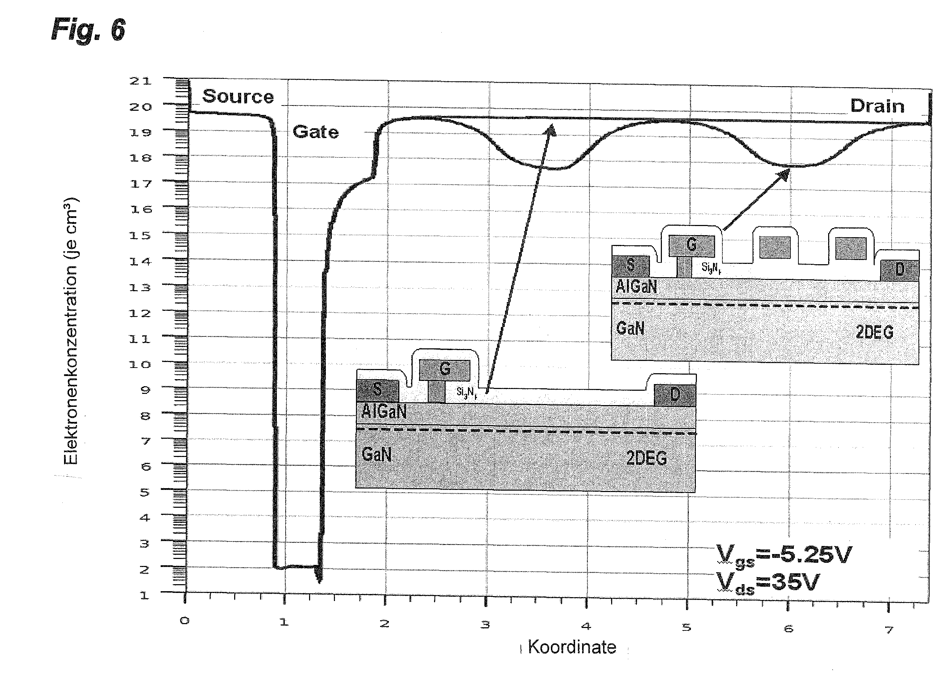

Fig. 6 zeigt die bei der in Fig. 5 zugrundeliegenden Feldverteilung die resultierende Elektronenkonzentration im 2DEG zwischen der Gate- und der Drainelektrode. Deutlich zu erkennen sind die aufgrund des Feldplattengitters zusätzlich verarmten Kanalgebiete.

Diese verarmten Bereiche sorgen für einen zusätzlichen Spannungsabfall entlang des Kanals und erhöhen damit die Durchbruchsspannungsfestigkeit.

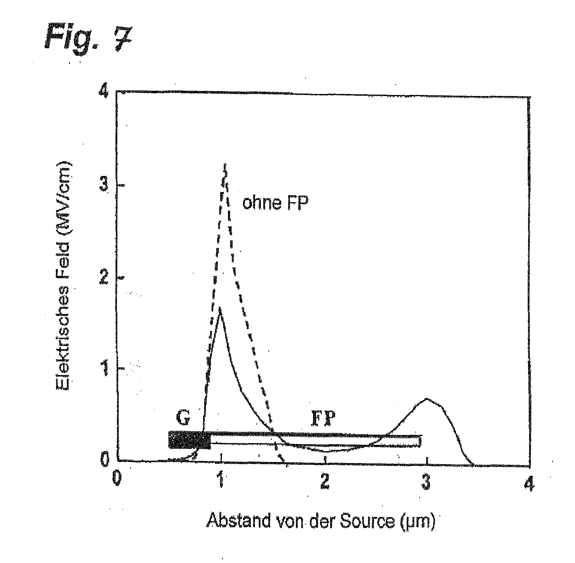

Fig. 7 zeigt eine schematische Darstellung einer simulierten Verteilung des elektrischen Felds im 2-DEG-Feld (zweidimensionales Elektronengas) in Source-Drain Richtung mit und ohne Feldplatten-Struktur. Auch hier reduziert die Feldplatten-Struktur die Spitze des elektrischen Feldes an der drainseitigen Kante des Gates.

Obwohl der erfindungsgemäße Transistor im bevorzugten Ausführungsbeispiel anhand eines HEMTs dargestellt wurde, gelten die oben gemachten Ausführungen auch analog für andere Transistorarten, insbesondere FET-Anwendungen wie MISFET und MOSFET. Der erfindungsgemäße Transistor kann als einzelner Transistor, als Array-Anordnung aus einer Vielzahl von gleichartigen Transistoren (Vielzahl von Fingern) oder auch in einem integrierten Schaltkreis verwendet werden.

### Bezugszeichenliste

- 10: HEMT-Bauelement
- 18: Aktive Fläche
- 19: 2DEG
- 20: Substrat
- 22: Nukleationsschicht
- 24: Pufferschicht
- 26: Barrierenschicht
- 28: Drainelektrode und Drainpad
- 30: Sourceelektrode und Sourcepad
- 32: Gate
- 33: Gateelektrode und Gatepad
- 34: Gate-Feldplatte
- 36: Passivierungsschicht
- 38: Schutzfilm
- 50: Feldplatte
- 52: Feldplatte
- 54: Feldplatte
- 56: Feldplatte
- 58: Feldplatte
- 60: Feldplatte
- Lₚ: Feldplatte: Länge der periodischen Anordnung
- Lₛ: Abstand zwischen zwei benachbarten Feldplatten
- Lₗ: Länge der Feldplatte
- L_{gf}: Länge der Gate-Feldplatte
- L_{g}: Gatelänge
- tₚ₁: Dicke der Passivierungsschicht
- tₚ₂: Dicke des Schutzfilms

## Patentansprüche

1. Verfahren zur Herstellung eines Halbleiterbauelements, mit folgenden Verfahrensschritten:
- Bereitstellen eines Substrats (20) mit einer darauf angeordneten aktiven Schichtstruktur umfassend mindestens eine Schicht (24, 26) aus einem halbleitenden Material, wobei die aktive Schichtstruktur (26) mit einem Sourcekontakt (30) und einem Drainkontakt (28) verbunden ist, und der Sourcekontakt (30) und der Drainkontakt (28) voneinander beabstandet sind,
- Aufbringen einer Passivierungsschicht (36) auf die aktive Schichtstruktur,
- Strukturieren der Passivierungsschicht durch Aussparungen,
- Aufbringen eines Gatekontakts (32) in eine der Aussparungen und direkt auf die aktive Schichtstruktur (26), wobei mindestens ein Teil des Gatekontakts (32) im Bereich zwischen Sourcekontakt (30) und Drainkontakt (28) angeordnet wird,
- Aufbringen einer Gate-Feldplatte (34) auf den Gatekontakt (32), wobei die Gate-Feldplatte (34) auf die Passivierungsschicht (36) aufgebracht und mit dem Gatekontakt (32) elektrisch verbunden wird, wobei zusätzlich mindestens zwei separate Feldplatten (50, 52, 54, 56, 58, 60) ausgebildet werden, **dadurch gekennzeichnet, dass** mindestens eine (50, 52, 54) der separaten Feldplatten gleichzeitig mit der Gate-Feldplatte (34) auf der Passivierungsschicht und mindestens eine (56, 58) der separaten Feldplatten in einer weiteren Aussparung gleichzeitig mit dem Gatekontakt (32) und direkt auf der aktiven Schichtstruktur (24, 26) so ausgebildet wird, dass die die Gate-Feldplatte (34) und die mindestens zwei separaten Feldplatten sich in einer zum Substrat (20) senkrechten Projektion auf die aktive Schichtstruktur nicht überlappen.

2. Verfahren nach einem der vorhergehenden Ansprüche,
**dadurch gekennzeichnet, dass**
mindestens zwei der separaten Feldplatten (56, 58) in Aussparungen der Passivierungsschicht (36) auf die aktive Schichtstruktur aufgebracht werden.

3. Verfahren nach einem der vorhergehenden Ansprüche,
**dadurch gekennzeichnet, dass**
die mindestens zwei separaten Feldplatten (50, 52, 54, 56, 58) streifenförmig und zueinander parallel ausgebildet werden.

4. Verfahren nach einem der vorhergehenden Ansprüche,
**dadurch gekennzeichnet, dass**
die aktive Schichtstruktur eine erste Schicht (24) aus einem ersten halbleitenden Material und eine zweite Schicht (26) aus einem zweiten halbleitenden Material aufweist, und sich die Bandlücke des ersten halbleitenden Materials von der Bandlücke des zweiten halbleitenden Materials unterscheidet und/oder sich die spontane oder piezoelektrische Polarisation des ersten halbleitenden Materials von der spontanen oder piezoelektrischen Polarisation des zweiten halbleitenden Materials unterscheidet, und das erste halbleitende Material und das zweite halbleitende Material derart gewählt sind, dass in der Grenzschicht zwischen erster Schicht (24) und zweiter Schicht (26) ein zweidimensionales Elektronengas (19) ausgebildet wird.

5. Verfahren nach Anspruch 1,
**dadurch gekennzeichnet, dass**
mindestens zwei andere der separaten Feldplatten (50, 52, 54) auf der Passivierungsschicht gleichzeitig mit dem Prozess zur Ausbildung des Gate-Feldplatte (34) und gleichzeitig mit dem Prozess zur Ausbildung der einen (56, 58) der separaten Feldplatten ausgebildet werden.

6. Verfahren nach Anspruch 5,
**dadurch gekennzeichnet, dass**
mindestens zwei andere der separaten Feldplatten (50) mit dem Gatekontakt (32) verbunden wird und/oder die mindestens eine andere der separaten Feldplatten (52, 54) mit dem Sourcekontakt (30) verbunden wird.

7. Halbleiterbauelement, aufweisend:
ein Substrat (20) mit einer darauf angeordneten aktiven Schichtstruktur umfassend mindestens eine Schicht (24, 26) aus einem halbleitenden Material, wobei auf der aktiven Schichtstruktur (24, 26) ein Sourcekontakt (30) und ein Drainkontakt (28) angeordnet ist, und der Sourcekontakt (30) und der Drainkontakt (28) voneinander beabstandet sind,
eine auf der aktiven Schichtstruktur angeordnete Passivierungsschicht (36) die durch Aussparungen strukturiert ist,
ein Gatekontakt (32), wobei mindestens ein Teil des Gatekontakts (32) in einer der Aussparungen und direkt auf der aktiven Schichtstruktur (24, 26) im Bereich zwischen Sourcekontakt (30) und Drainkontakt (28) angeordnet ist,
eine Gate-Feldplatte (34), die mit dem Gatekontakt (32) elektrisch verbunden ist, wobei die Gate-Feldplatte (34) direkt auf die Passivierungsschicht (36), die über der aktiven Schichtstruktur angeordnet ist, aufgebracht ist,
zusätzlich mindestens zwei separate Feldplatten (50, 52, 54, 56, 58), **dadurch gekennzeichnet, dass** mindestens eine (50, 52, 54) der separaten Feldplatten direkt auf der Passivierungsschicht (36) und
mindestens eine (56, 58) der separaten Feldplatten in einer weiteren Aussparung und direkt
auf der aktiven Schichtstruktur (24, 26) so angeordnet sind, dass die Gate-Feldplatte (34) und die mindestens zwei separaten Feldplatten sich in einer zum Substrat (20) senkrechten Projektion auf die aktive Schichtstruktur nicht überlappen.

8. Halbleiterbauelement nach Anspruch 7,
**dadurch gekennzeichnet, dass**
die mindestens zwei separaten Feldplatten (50, 52, 54, 56, 58) streifenförmig und zueinander parallel ausgebildet sind.

9. Halbleiterbauelement nach einem der Ansprüche 7 oder 8,
**dadurch gekennzeichnet, dass**
mindestens zwei andere der separaten Feldplatten (50, 52, 54) direkt auf der Passivierungsschicht (36) angeordnet sind.

10. Halbleiterbauelement nach Anspruch 9,
**dadurch gekennzeichnet, dass**
die mindestens zwei anderen separaten Feldplatten (50, 52, 54) mit unterschiedlichen elektrischen Potentialen (28, 30, 32) verbunden sind.

11. Halbleiterbauelement nach einem der Ansprüche 9 oder 10,,
**dadurch gekennzeichnet, dass**
mindestens eine der anderen separaten Feldplatten (50) mit dem Gatekontakt (32) verbunden ist und/oder mindestens eine der weiteren separaten Feldplatten (52, 54) mit dem Sourcekontakt (30) verbunden ist.

12. Halbleiterbauelement nach einem der Ansprüche 7 bis 11,
**dadurch gekennzeichnet, dass**
die aktive Schichtstruktur eine erste Schicht (24) aus einem ersten halbleitenden Material und eine zweite Schicht (26) aus einem zweiten halbleitenden Material aufweist, und sich die Bandlücke des ersten halbleitenden Materials von der Bandlücke des zweiten halbleitenden Materials unterscheidet und/oder sich die spontane oder piezoelektrische Polarisation des ersten halbleitenden Materials von der spontanen oder piezoelektrischen Polarisation des zweiten halbleitenden Materials unterscheidet, und das erste halbleitende Material und das zweite halbleitende Material derart gewählt sind, dass sich in der Grenzschicht zwischen erster Schicht (24) und zweiter Schicht (26) ein zweidimensionales Elektronengas (19) ausbildet.

## Claims

1. A method of manufacturing a semiconductor component, with the following method steps:
- providing a substrate (20) with an active layer structure disposed thereon, comprising at least one layer (24, 26) made of a semiconducting material, the active layer structure (26) being connected to a source contact (30) and a drain contact (28), and the source contact (30) and the drain contact (28) being spaced apart from each other,
- depositing a passivation layer (36) on the active layer structure,
- structuring the passivation layer by means of recesses,
- depositing a gate contact (32) in one of the recesses and directly on the active layer structure (26), wherein at least a part of the gate contact (32) is disposed in the area between the source contact (30) and the drain contact (28),
- depositing a gate field plate (34) on the gate contact (32), wherein the gate field plate (34) is deposited on the passivation layer and is electrically connected to the gate contact (32), wherein
additionally at least two separate field plates (50, 52, 54, 56, 58, 60) are formed, **characterized in that** at least one (50, 52, 54) of the separate field plates is formed on the passivation layer at the same time as the gate field plate (34), and at least one (56, 58) of the separate field plates is formed in a further recess and directly on the active layer structure (24, 26) at the same time as the gate contact (32) such that the gate field plate (34) and the at least two separate field plates do not overlap in a projection onto the active layer structure, which is perpendicular to the substrate (20).

2. The method according to any one of the preceding claims,
**characterized in that**
at least two of the separate field plates (56, 58) in recesses of the passivation layer (36) are deposited on the active layer structure.

3. The method according to any one of the preceding claims,
**characterized in that**
the at least two separate field plates (50, 52, 54, 56, 58) are formed in a stripe shape and parallel to each other.

4. The method according to any one of the preceding claims,
**characterized in that**
the active layer structure has a first layer (24) made of a first semiconducting material and a second layer (26) made of a second semiconducting material, and the band gap of the first semiconducting material is different from the band gap of the second semiconducting material and/or the spontaneous or piezoelectric polarization of the first semiconducting material is different from the spontaneous or piezoelectric polarization of the second semiconducting material, and the first semiconducting material and the second semiconducting material are chosen such that a two-dimensional electron gas (19) is formed in the boundary layer between the first layer (24) and the second layer (26).

5. The method according to Claim 1, **characterized in that**
at least two others of the separate field plates (50, 52, 54) are formed on the passivation layer at the same time as the process for forming the gate field plate (34) and at the same time as the process for forming the one (56, 58) of the separate field plates.

6. The method according to Claim 5, **characterized in that**
at least two others of the separate field plates (50) are connected to the gate contact (32) and/or the at least one other of the separate field plates (52, 54) is connected to the source contact (30).

7. A semiconductor element, comprising:
a substrate (20) with an active layer structure disposed thereon, comprising at least one layer (24, 26) made of a semiconducting material, a source contact (30) and a drain contact (28) being disposed on the active layer structure (24, 26) and the source contact (30) and the drain contact (28) being spaced apart from each other,
a passivation layer (36) disposed on the active layer structure layer, said passivation layer being structured by means of recesses,
a gate contact (32), wherein at least a part of the gate contact (32) is disposed in one of the recesses and directly on the active layer structure (24, 26) in the area between the source contact (30) and the drain contact (28),
a gate field plate (34) which is electrically connected to the gate contact (32), wherein the gate field plate (34) is deposited directly on the passivation layer (36) which is disposed above the active layer structure,
additionally at least two separate field plates (50, 52, 54, 56, 58), **characterized in that** at least one (50, 52, 54) of the separate field plates is deposited directly on the passivation layer (36) and at least one (56, 58) of the separate field plates is disposed in a further recess directly on the active layer structure (24, 28) such that the gate field plate (34) and the at least two separate field plates do not overlap in a projection onto the active layer structure, which is perpendicular to the substrate (20).

8. The semiconductor element according to Claim 7, **characterized in that**
the at least two separate field plates (50, 52, 54, 56, 58) are formed in a stripe shape and parallel to each other.

9. The semiconductor element according to any one of Claims 7 or 8, **characterized in that**
at least two others of the separate field plates (50, 52, 54) are disposed directly on the passivation layer (36).

10. The semiconductor element according to Claim 9, **characterized in that**
the at least two other separate field plates (50, 52, 54) are connected to different electrical potentials (28, 30, 32).

11. The semiconductor element according to any one of Claims 9 or 10, **characterized in that**
at least one of the other separate field plates (50) is connected to the gate contact (32) and/or at least one of the additional separate field plates (52, 54) is connected to the source contact (30).

12. The semiconductor element according to any one of Claims 7 to 11, **characterized in that**
the active layer structure has a first layer (24) made of a first semiconducting material and a second layer (26) made of a second semiconducting material, and the band gap of the first semiconducting material is different from the band gap of the second semiconducting material and/or the spontaneous or piezoelectric polarization of the first semiconducting material is different from the spontaneous or piezoelectric polarization of the second semiconducting material, and the first semiconducting material and the second semiconducting material are chosen such that a two-dimensional electron gas (19) forms in the boundary layer between the first layer (24) and the second layer (26).

## Revendications

1. Procédé de fabrication d'un dispositif à semi-conducteur, avec les étapes de procédé suivantes :
- fourniture d'un substrat (20) avec une structure à couche active qui est disposée dessus, comprenant au moins une couche (24, 26) réalisée dans un matériau semi-conducteur, la structure à couche active (26) étant connectée à un contact de source (30) et à un contact de drain (28), et le contact de source (30) et le contact de drain (28) étant espacés l'un de l'autre ;
- application d'une couche de passivation (36) sur la structure à couche active ;
- structuration de la couche de passivation par des évidements,
- application d'un contact de grille (32) dans un des évidements et directement sur la structure à couche active (26), au moins une partie du contact de grille (32) étant disposée dans la zone entre le contact de source (30) et le contact de drain (28),
- application d'une plaque de champ de grille (34) sur le contact de grille (32), la plaque de champ de grille (34) étant appliquée sur la couche de passivation (36) et étant connectée électriquement au contact de grille (32),
au moins deux plaques de champ (50, 52, 54, 56, 58, 60) séparées étant constituées en plus,
**caractérisé en ce que**
au moins une (50, 52, 54) des plaques de champ séparées est constituée simultanément avec la plaque de champ de grille (34) sur la couche de passivation et au moins une (56, 58) des plaques de champ séparées est constituée dans un autre évidement simultanément avec le contact de grille (32) et directement sur la structure à couche active (24, 26) de telle sorte que la plaque de champ de grille (34) et les au moins deux plaques de champ séparées ne se chevauchent pas dans une projection perpendiculaire au contact de grille (20) sur la structure de couche active.

2. Procédé selon l'une des revendications précédentes,
**caractérisé en ce que**
au moins deux des plaques de champ (56, 58) séparées sont appliquées dans des évidements de la couche de passivation (36) sur la structure à couche active.

3. Procédé selon l'une des revendications précédentes,
**caractérisé en ce que**
les au moins deux plaques de champ (50, 52, 54, 56, 58) séparées sont constituées en forme de bande et parallèlement entre elles.

4. Procédé selon l'une des revendications précédentes,
**caractérisé en ce que**
la structure à couche active présente une première couche (24) réalisée dans un premier matériau semi-conducteur et une deuxième couche (26) réalisée dans un deuxième matériau semi-conducteur, et **en ce que** la bande interdite du premier matériau semi-conducteur se distingue de la bande interdite du deuxième matériau semi-conducteur et/ou **en ce que** la polarisation spontanée ou piézoélectrique du premier matériau semi-conducteur se distingue de la polarisation spontanée ou piézoélectrique du deuxième matériau semi-conducteur, et le premier matériau semi-conducteur et le deuxième matériau semi-conducteur sont choisis de telle sorte que, dans la couche limite entre la première couche (24) et la deuxième couche (26), il est constitué un gaz électronique (19) bidimensionnel.

5. Procédé selon la revendication 1,
**caractérisé en ce que**
au moins deux autres des plaques de champ (50, 52, 54) séparées sont constituées sur la couche de passivation simultanément avec le processus de constitution de la plaque de champ de grille (34) et simultanément avec le processus de constitution de l'une (56, 58) des plaques de champ séparées.

6. Procédé selon la revendication 5,
**caractérisé en ce que**
au moins deux autres des plaques de champ (50) séparées sont connectées au contact de grille (32) et/ou **en ce que** l'autre, au moins au nombre de un, des plaques de champ (52, 54) séparées est connectée au contact de source (30).

7. Dispositif à semi-conducteur, présentant:
un substrat (20) avec une structure à couche active disposée dessus, comprenant au moins une couche (24, 26) réalisée dans un matériau semi-conducteur, un contact de source (30) et un contact de drain (28) étant disposés sur la structure à couche active (24, 26), et le contact de source (30) et le contact de drain (28) étant espacés l'un de l'autre,
une couche de passivation (36) disposée sur la structure à couche active, qui est structurée par des évidements,
un contact de grille (32), au moins une partie du contact de grille (32) étant disposée dans un des évidements et directement sur la couche de structure active (24, 26) dans la zone entre le contact de source (30) et le contact de drain (28),
une plaque de champ de grille (34) qui est connectée électriquement au contact de grille (32), la plaque de champ de grille (34) étant appliquée directement sur la couche de passivation (36) qui est disposée sur la structure à couche active,
en plus au moins deux plaques de champ (50, 52, 54, 56, 58) séparées,
**caractérisé en ce qu'**au moins une (50, 52, 54) des plaques de champ séparées est disposée directement sur la couche de passivation (36), et au moins une (56, 58) des plaques de champ séparées est disposée dans un autre évidement et directement sur la couche de structure active (24, 26) de telle sorte que la plaque de champ de grille (34) et les au moins deux plaques de champ séparées ne se chevauchent pas dans une projection perpendiculaire au substrat (20) sur la structure à couche active.

8. Dispositif à semi-conducteur selon la revendication 7,
**caractérisé en ce que**
les au moins deux plaques de champ (50, 52, 54, 56, 58) séparées sont constituées en forme de bande et parallèlement entre elles.

9. Dispositif à semi-conducteur selon l'une des revendications 7 ou 8,
**caractérisé en ce que**
au moins deux autres des plaques de champ (50, 22, 54) séparées sont disposées directement sur la couche de passivation (36).

10. Dispositif à semi-conducteur selon la revendication 9,
**caractérisé en ce que**
les au moins deux autres plaques de champ (50, 52, 54) séparées sont connectées à des potentiels électriques (28, 30, 32) différents.

11. Dispositif à semi-conducteur selon l'une des revendications 9 ou 10,
**caractérisé en ce que**
au moins une des autres plaques de champ (50) séparées est connectée au contact de grille (32) et/ou au moins une des autres plaques de champ (52, 54) séparées est connectée au contact de source (30).

12. Dispositif à semi-conducteur selon l'une des revendications 7 à 11,
**caractérisé en ce que**
la structure à couche active présente une première couche (24) réalisée dans un premier matériau semi-conducteur et une deuxième couche (26) réalisée dans un deuxième matériau semi-conducteur, et **en ce que** la bande interdite du premier matériau semi-conducteur se distingue de la bande interdite du deuxième matériau semi-conducteur et/ou **en ce que** la polarisation spontanée ou piézoélectrique du premier matériau semi-conducteur se distingue de la polarisation spontanée ou piézoélectrique du deuxième matériau semi-conducteur, et le premier matériau semi-conducteur et le deuxième matériau semi-conducteur sont choisis de telle sorte que, dans la couche limite entre la première couche (24) et la deuxième couche (26), il est constitué un gaz électronique (19) bidimensionnel.
